# EUROPÄISCHE PATENTSCHRIFT

(11) **EP 1 791 178 B1**
(45) Veröffentlichungstag und Bekanntmachung des Hinweises auf die Patenterteilung: **07.03.2012**
(21) Anmeldenummer: 06023090.1
(22) Anmeldetag: 07.11.2006
(51) Int. Cl.: H01L 23/48, H01L 25/07

(54) **Leistungshalbleitermodul in Druckkontaktausführung**
Pressure contact type power semiconductor module
Module de puissance semi-conducteur de type à contact par pression

(30) Priorität: 23.11.2005 DE 102005055713
(43) Veröffentlichungstag der Anmeldung: 30.05.2007
(73) Patentinhaber: Semikron Elektronik GmbH & Co. KG Patentabteilung, 90431 Nürnberg (DE)
(72) Erfinder: Tauscher, Björn, 91183 Abenberg (DE)

(56) Entgegenhaltungen:
- EP-A1- 1 291 914
- EP-A2- 0 309 894
- EP-A2- 0 324 929
- US-A- 4 263 607

## Beschreibung

Erfindung beschreibt ein Leistungshalbleitermodul wie es grundsätzlich aus einer Vielzahl von Druckschriften bekannt ist. Derartige Leistungshalbleitermodule weisen bekanntermaßen ein isolierendes Kunststoffgehäuse auf. Hierin befindet sich ein Substrat mit schaltungsgerecht angeordneten Leistungshalbleiterbauelementen. Weiterhin weisen derartige Leistungshalbleitermodule nach außen führende Anschlusselemente für Lastanschlüsse, sowie für Hilfsanschlüsse, zur elektrischen Verbindung der inneren Schaltungsanordnung auf.

Einen Ausgangspunkt dieser Erfindung bildet die nicht vorveröffentlichte Druckschrift DE 10 2004 050 588 A1. Diese offenbart ein Leistungshalbleitermodul in Druckkontaktausführung mit einer Grundplatte und einem hierauf angeordnetem Gehäuse. Das Gehäuse umschließt zwei schaltungsgerecht verbundene Leistungshalbleiterbauelemente, hier beispielhaft Thyristoren. Das Leistungshalbleitermodul weist zur äußeren elektrischen Verbindung der Leistungshalbleiterbauelemente eine Mehrzahl von Last- und Hilfsanschlüssen auf. Diese Hilfsanschlüsse werden gebildet aus einem lsolierstoffformkörper mit darin angeordnetem Federelement und damit verbundenem Stecker, sowie einer Verbindungsleitung zu einem externen Steckkontakt. Diese aufwändige Ausgestaltung ist bevorzugt für die besonders leistungsfähigen und dauerhaltbaren Leistungshalbleitermodul in Druckkontaktausführung.

Einen weiteren Ausgangspunkt der Erfindung bildet die DE 199 14 741 A1. Diese offenbart beispielhaft ein Leistungshalbleitermodul ohne Grundplatte. Bei derartigen Leistungshalbleitermodulen wird dessen Substrat, das von dem Gehäuse umschlossen wird, direkt auf einem Kühlbauteil angeordnet. Auf dem Substrat selbst sind auf einer Mehrzahl von Leiterbahnen Leistungshalbleiterbauelementen angeordnet und schaltungsgerecht miteinander verbunden. Die nach Außen führenden Last- wie auch Hilfsanschlusselemente sind als Metallformkörper ausgebildet, die mit dem Substrat mittels einer Drahtbondverbindung verbunden sind.

In weiteren, grundsätzlich ähnlichen, Ausgestaltungen von Leistungshalbleitermodulen sind auch Lötverbindungen zwischen den Leiterbahnen und den Anschlusselementen bekannt. Nachteilig hierbei ist die im Vergleich zu druckkontaktierten Ausgestaltungen geringere Dauerhaltbarkeit oder auch Funktionssicherheit derartiger Verbindungen. Aus der DE 196 30 173 A1 sind weiterhin Leistungshalbleitermodul mit im Gehäuse angeordneten Federelementen als Anschlusselemente bekannt. Diese gestatten eine einfache und einer automatisierten Fertigung zugängliche Ausgestaltung.
[04a] Weiterhin zählen zum technologischen Hintergrund Leistungshalbleitermodule, meist ausgebildet als Scheibenzellen, bei denen das Leistungshalbleiterbauelement mit zwei metallischen Anschlussleitern, zwischen die das Leistungshalbleiterbauelement gespannt ist, kontaktiert wird. Aus der EP 0 324 929 A2 und der EP 0 309 894 A2 sind beispielhaft derartige Scheibenzellen bekannt, bei denen ein Hilfsanschluss, hier der Steueranschluss des Leistungshalbleiterbauelements, mittels eine Federanordung auf die zugehörige Kontaktfläche gedrückt wird.
Die EP 1 291 914 A1 offenbart eine derartiges Leistungshalbleitermodul, bei dem einer der beiden Lastanschlusselemente mittels einer Federanordnung auf das andere Lastanschlusselement gedrückt wird und die Kontaktierung des ersten Lastanschlusselements durch die Druckeinrichtung hindurch erfolgt.
Aus der US 4,263,607 ist es bekannt derartige Lastanschlusselemente mit dazwischen angeordnetem Leistungshalbleiterbauelement durch eine externe Klemmeinrichtung zu verspannen. Der Steueranschluss wird hierbei ebenfalls mittels einer Federanordnung auf die zugehörige Kontaktfläche des Leistungshalbleiterbauelements gedrückt.

Der Erfindung liegt die Aufgabe zugrunde ein Leistungshalbleitermodul, mit Anschlusselementen vorzustellen, die eine hohe Funktionssicherheit der elektrischen Verbindung mit einer einfachen Fertigung des Leistungshalbleitermoduls kombinieren.

Die Aufgabe wird erfindungsgemäß gelöst, durch die Maßnahmen der Merkmale des Anspruchs 1. Bevorzugte Ausführungsformen sind in den Unteransprüchen beschrieben.

Der erfinderische Gedanke geht aus von einem Leistungshalbleitermodul, vorzugsweise mit Grundplatte und mindestens einem hierauf angeordneten Substrat. Das Substrat ist elektrisch isolierend zur Grundplatte ausgebildet und weist auf seiner ersten, dem Modulinneren zugewandten, Hauptfläche eine Mehrzahl von Leiterbahnen auf. Mindestens ein Leistungshalbleiterbauelement ist auf einer dieser Leiterbahnen angeordnet und schaltungsgerecht, beispielhaft mittels Drahtbondverbindungen, verbunden.

Das erfindungsgemäße Leistungshalbleitermodul weist nach Außen führende Anschlusselemente für Last- und Hilfsanschlüsse auf. Diese Anschlusselemente sind im Inneren mit Leiterbahnen des Substrats oder direkt mit Kontaktflächen der Leistungshalbleiterbauelemente verbunden.

Mindestens eines dieser Anschlusselemente wird aus einem ersten federnd ausgestalteten Leitungsabschnitt und einem zweiten starren Leitungsabschnitt sowie aus einem Isolierstoffformkörper gebildet. Der erste Leitungsabschnitt ist hierbei mit einer Leiterbahn oder einer Kontaktfläche eines Leistungshalbleiterbauelements elektrisch leitend verbunden, wogegen der zweite Leitungsabschnitt den ersten mit dem externen Anschluss verbindet. Weiterhin weist das Anschlusselement einen Isolierstoffformkörper auf, der mit mindestens einem Leitungsabschnitt teilweise form- oder stoffschlüssig verbunden ist.

Dieser Isolierstoffformkörper weist mindestens eine Anschlagfläche zu einem hierzu zugeordneten Widerlager des Gehäuses auf. Dies bildet einen ersten Teil der Arretierung des Anschlusselements im Gehäuse. Weiterhin weist der Isolierstoffformkörper einen Bestandteil einer Schnapp- Rast- Verbindung mit dem Gehäuse auf, die den zweiten Teil der Arretierung bildet. Hierbei ist es bevorzugt, wenn der Isolierstoffformkörper die freigestellte Rastnase und das Gehäuse die zugeordnete Rastkante aufweisen.

Durch Rasten der Schnapp- Rast- Verbindung wird durch die geeignete Anordnung des Isolierstoffformkörpers im Gehäuse Druck auf den ersten Teil des Anschlusselements eingeleitet. Somit ist das Anschlusselement in seiner Gesamtheit im Inneren des Leistungshalbleitermoduls als Druckkontaktausführung mit deren bekannten Vorteilen ausgebildet.

Es ist besonders bevorzugt die Hilfsanschlüsse des Leistungshalbleitermoduls mittels der erfindungsgemäßen Ausgestaltung der Anschlusselemente auszubilden.

Die erfinderische Lösung wird an Hand der Ausführungsbeispiele der Fig. 1 bis 4 weiter erläutert.

Fig. 1 zeigt ein erfindungsgemäßes Leistungshalbleitermodul in Draufsicht.

Fig. 2 zeigt ein erfindungsgemäßes Leistungshalbleitermodul im seitlichen Schnitt.

Fig. 3 zeigt die Anordnung eines Anschlusselements des erfindungsgemäßen Leistungshalbleitermoduls in dreidimensionaler Darstellung.

Fig. 4 zeigt einen Teil eines Anschlusselements des erfindungsgemäßen Leistungshalbleitermoduls in dreidimensionaler Darstellung.

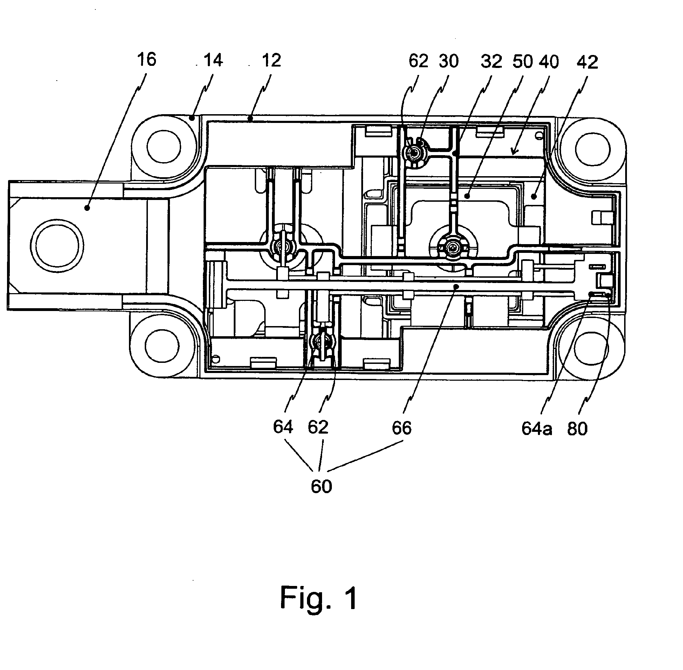

Fig. 1 zeigt ein erfindungsgemäßes Leistungshalbleitermodul in Draufsicht. Dargestellt ist hierbei ein Thyristormodul hoher Leistung mit zwei Thyristoren (50), die auf Leiterbahnen eines jeweils eigenen Substrats angeordnet sind. Hierbei ist es bevorzugt ausschließlich die Hilfsanschlusselemente (60) für die Ansteuerung der Thyristoren (50) gemäß der Erfindung auszubilden. Bei Leistungshalbleitermodulen geringerer Leistung ist es durchaus bevorzugt die Last- (16) und / oder die Hilfsanschlusselemente (60) gemäß der Erfindung auszubilden.

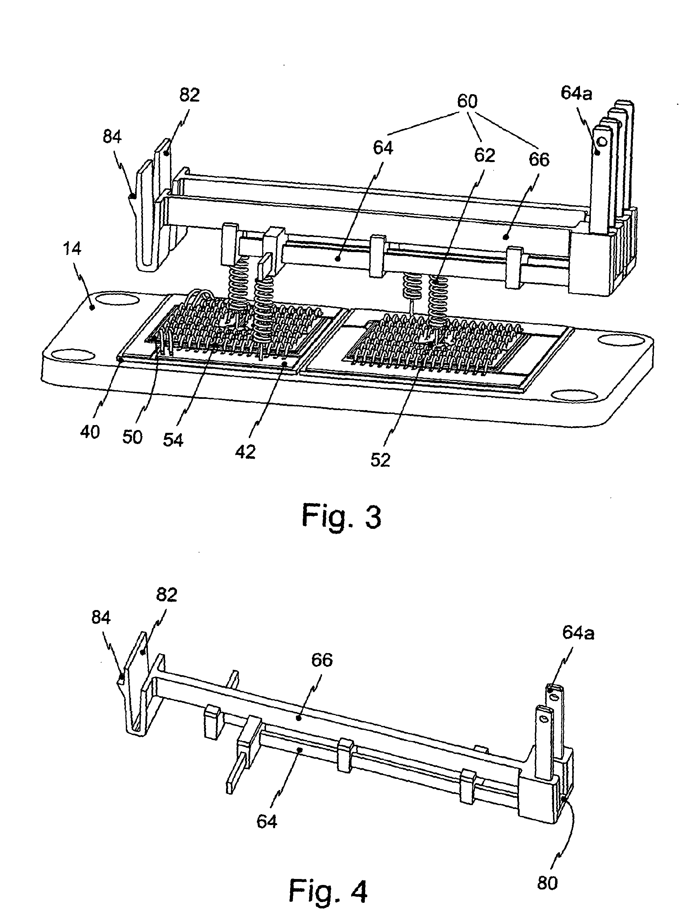

Dargestellt ist eine Grundplatte (14), ein hierauf angeordnetes Gehäuses, welches die (12) Substrate rahmenartig umschließt. Diese sind jeweils als ein Isolierstoffkörper (40), vorzugsweise aus einer Industriekeramik, ausgebildet mit auf der dem Modulinneren zugewandten Seite angeordneten metallischen Leiterbahnen (42). Auf diesen Leiterbahnen sind die Leistungshalbleiterbauelemente (50) angeordnet und mittels Drahtbondverbindungen (vgl. Fig. 3, 54) schaltungsgerecht verbunden. Die ersten Leitungsabschnitte der erfindungsgemäßen Anschlusselemente (60) sind hier ausgebildet als Tonnenfedern (62) zur elektrischen Kontaktierung von Kontaktflächen der Leistungshalbleiterbauelemente (50) sowie zur elektrischen Kontaktierung von Leiterbahnen (42).

Ebenfalls dargestellt sind zweite Leitungsabschnitte (64) der Anschlusselemente (60), wobei diese von dem zugeordneten Isolierstoffformkörper (66) teilweise umschlossen und stoffbündig mit diesem verbunden sind.

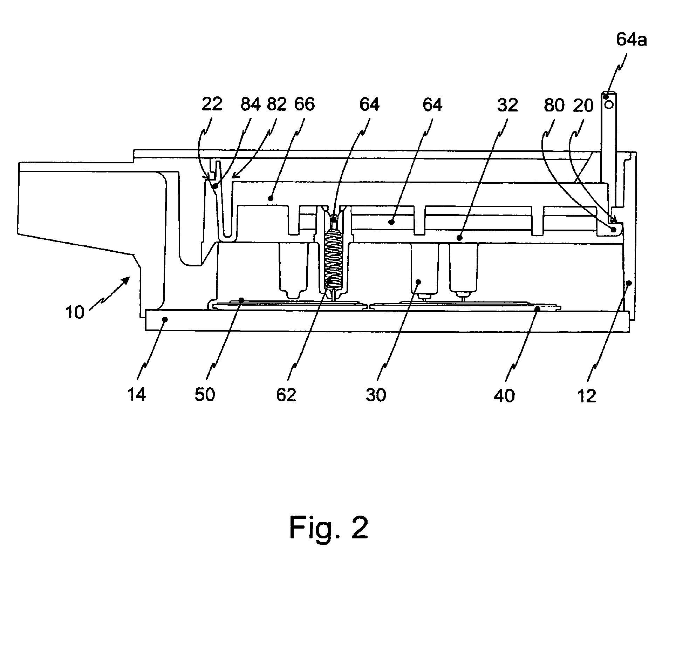

Fig. 2 zeigt ein erfindungsgemäßes Leistungshalbleitermodul gemäß Fig. 1 im seitlichen Schnitt. Hierbei ist die Anordnung des Gehäuses (10) auf der Grundplatte ersichtlich, ebenso wie die beiden vom rahmenartigen Teil (12) des Gehäuse (10) umschlossenen Substrate (40), mit den, auf zugeordneten Leiterbahnen (42), angeordneten Leistungshalbleiterbauelemente (50).

Der jeweils erste Leitungsabschnitt (62) eines erfindungsgemäßen Anschlusselements (60) ist in einer als Führung dienenden Ausformung (30) des Gehäuses (10) angeordnet, wobei dieser erste Leitungsabschnitt selbst als Tonnenfeder (62) ausgebildet ist. Diese Ausformungen (30) sind mit der Wandung (12) des Gehäuses (10) mittels geeigneter Gehäuseteile (32; vgl. auch Fig. 1), die vorzugsweise zusätzlich als Versteifungsstruktur des Gehäuses (10) dienen verbunden.

Das Anschlusselement (60) weist weiterhin einen zweiten Leitungsabschnitt (64) auf, der als Metallformkörper ausgebildet ist und teilweise mit einem Isolierstoffformkörper (66) verbunden ist. Dieser Isolierstoffformkörper (66) weist an seinem ersten Ende eine Anschlagfläche (80) auf, die an einem zugeordneten Widerlager (20) des Gehäuses (10) angeordnet ist und eine Bewegung des Isolierstoffformkörpers (66) in Richtung von den Leistungshalbleiterbauelementen (50) weg verhindert. Am gegenüberliegenden Ende des Isolierstoffformkörpers (66) weist dieser einen freigestellten beweglichen Abschnitt (82) auf, der eine Rastnase (84) aufweist und zusammen mit der Rastkante (22) des Gehäuses (10) eine Schnapp- Rast- Verbindung des Isolierstoffformkörpers (66) und somit des Anschlusselements (60) mit dem Gehäuse (10) ausbildet.

Durch die dargestellte Ausgestaltung des Isolierstoffformkörpers wird auf den ersten Leitungsabschnitt, die Tonnenfeder (62), Druck in Richtung der Grundplatte (14) eingeleitet und somit eine sichere elektrische Verbindung der Tonnenfeder (62) zur zugeordneten Kontaktfläche (vgl. Fig. 3, 52) des Leistungshalbleiterbauelements (50) bzw. zur Leiterbahn (vgl. Fig. 3, 42) des Substrats (40) ausgebildet.

Der aus dem Gehäuse (10) herausragende Teil (64a) des zweiten Leitungsabschnitts (64) des Anschlusselements (60) ist vorzugsweise, wie dargestellt, als Steckkontakt nach dem Stand der Technik ausgebildet und dient dem externen Anschluss.

Fig. 3 zeigt die Anordnung eines Anschlusselements (60) des erfindungsgemäßen Leistungshalbleitermoduls in dreidimensionaler Darstellung, wobei aus Gründen der Übersichtlichkeit auf das Gehäuse verzichtet wurde. Dargestellt ist wiederum die Grundplatte (14) mit zwei Substraten (40). Diese dienen der thermischen Ankopplung bei gleichzeitiger elektrischen Isolation zur Grundplatte (14), bzw. bei einem Leistungshalbleitermodul ohne Grundplatte, zum Kühlbauteil.

Auf der dem Modulinneren zugewandten Seite sind metallische Leiterbahnen (42) nach dem Stand der Technik auf den Substraten (40) angeordnet. In dieser speziellen Ausgestaltung eines Thyristormoduls ist auf jedem Substrat (40) nur ein Thyristor (50) angeordnet, wobei die Erfindung nicht auf diesen speziellen Fall eingeschränkt ist.

Dargestellt sind hier Anschlusselemente (60) für je Thyristor (50) einen Steueranschluss und einen Hilfskathodenanschluss, wobei der Steueranschluss direkt mit der zugeordneten Kontaktfläche (52) des Thyristors (50) und der Hilfskathodenanschluss mit einer zugeordneten Leiterbahn (42) des Substrats (40) verbunden ist. Diese Verbindung ist ausgebildet als der erste Leitungsabschnitt (62) eines erfindungsgemäßen Anschlusselements (60), hier als Tonnenfeder. Diese Tonnenfeder (62) ist nicht einstückig mit dem zweiten Leitungsabschnitt (64) des Anschlusselements (60) verbunden. Dieser zweite Leitungsabschnitt (64) wird gebildet aus einem Metallformkörper, der stoffbündig mit einem Isolierstoffformkörper (66) verbunden ist. Der Metallformkörper (64) bildet an seinem ersten Ende eine Kontaktfläche zur Tonnenfeder (62) und an seinem zweiten Ende einen Stecker aus.

Es kann ebenso bevorzugt sein, wenn die beiden Leitungsabschnitte einstückig ausgebildet sind, wobei der erste Leitungsabschnitt hierbei in beliebiger Weise nach dem Stand der Technik federnd ausgestaltet sein kann.

Der Isolierstoffformkörper (66) besteht vorzugsweise aus dem gleichen Kunststoff, wie das Gehäuse (10) und weist an seinem ersten Ende eine Ausnehmung (80) auf, die als Anschlagfläche für die Verankerung (20) im Gehäuse (10) ausgebildet ist. Das zweite Ende des Isolierstoffformkörpers (66) weist eine freigestellten beweglichen Abschnitt (82) auf, der eine Rastnase (84) aufweist.

Die zweistückige Ausbildung des Leitungsabschnitts des Anschlusselements (60), als eine Tonnenfeder (62) und als ein starrer Metallformkörper (64) ist besonders bevorzugt, da hier über den zweiten Leitungsabschnitt (64) mittels des Isolierstoffformkörpers (66) und seiner Verankerung im Gehäuse (10) Druck auf die Tonnenfeder (62) eingeleitet wird. Somit wird die Tonnenfeder (62) einerseits mit der Kontaktfläche (52) des Leistungshalbleiterbauelements (50) bzw. der Leiterbahn (42) des Substrats (40) und anderseits mit dem zweiten Leitungsabschnitt (64) dauerhaft elektrisch leitend verbunden.

Diese Ausgestaltung weist besondere Vorzüge bei der Herstellung des Leistungshalbleitermoduls auf, da hierbei erst die Tonnenfeder (62) in die Ausformung (30) des Gehäuses (10) bestückt werden kann und in einem weiteren Schritt der weitere Teil des Anschlusselements; der zweite Leitungsabschnitt (64) mit dem stoffbündig verbundenen Isolierstoffformkörper (66), angeordnet wird und hierbei die Tonnenfeder (62) mit Druck beaufschlagt wird.

Bei der einstückigen, wie auch in speziellen Anwendungsfällen der zweitiligen, Ausgestaltung der Leitungsabschnitte kann es auch bevorzugt sein keine Druckkontaktierung mit der Kontaktfläche des Leistungshalbleiterbauelements oder der Leiterbahn des Substrats auszubilden. Hierbei sind dann andere bekannte Verbindungstechniken, wie beispielhaft Löt- oder Klebeverbindungen bevorzugt.

Fig. 4 zeigt einen Teil eines Anschlusselements (60) des erfindungsgemäßes Leistungshalbleitermoduls in dreidimensionaler Darstellung. Hierbei ist besonders zu beachten, dass die zweiten Leitungsabschnitte (64) von zwei Anschlusselementen einen gemeinsamen lsolierstoffformkörper (66) aufweisen. Dies ist besonders bevorzugt, da hierbei der beschriebe Herstellungsaufwand weiter reduziert wird.

Dargestellt sind hier zwei zweite Leitungsabschnitt (64), die als starrer Metallformkörper mittels Stanz- Biegetechnik hergestellter sind. Somit ist es ohne besonderen Aufwand möglich beliebige Positionen der Tonnenfedern (62, vgl. Fig. 3) im Leistungshalbleitermodul mit dem Metallformkörper (64) zu verbinden.

Als besonders geeignete Verbindung zwischen dem lsolierstoffformkörper (66) und dem zweiten Leitungsabschnitt (64) erweisen sich Kunststoffspritzverfahren nach dem Stand der Technik. Es ist besonders vorteilhaft, wenn der Metallformkörper (64) nur teilweise in den lsolierstoffformkörper (66) eingebettet ist, weil dieser hierdurch möglichst kompakt ausgestaltet werden kann.

## Patentansprüche

1. Leistungshalbleitermodul mit einem Gehäuse (10), mindestens einem Substrat (40), mindestens einem schaltungsgerecht angeordnet und verbundenem Leistungshalbleiterbauelement (50), hiermit elektrisch leitend verbundenen und nach außen führenden Anschlusselementen (60) für Last- (16) und Hilfsanschlüsse,
wobei mindestens ein Anschlusselement (60) gebildet wird aus einem ersten federnd ausgestalteten Leitungsabschnitt (62) und einem zweiten starren Leitungsabschnitt (64) und aus einem Isolierstoffformkörper (66), wobei mindestens ein Leitungsabschnitt (62, 64) teilweise mit dem Isolierstoffformkörper (66) verbunden ist, **dadurch gekennzeichnet,**
**dass** dieser Isolierstoffformkörper (66) mindestens eine Anschlagfläche (80) zu einem zugeordneten Widerlager (20) des Gehäuses (10), sowie einen Teil einer Schnapp-Rast- Verbindung (22, 82, 84) mit dem Gehäuse (10) aufweist.

2. Leistungshalbleitermodul nach Anspruch 1,
wobei das Anschlusselement (60) mit einer Kontaktfläche (52) eines Leistungshalbleiterbauelements (50) oder mit einer Leiterbahn (42) eines Substrats (40) verbunden ist.

3. Leistungshalbleitermodul nach Anspruch 1,
wobei der erste Leitungsabschnitt (62) eines Anschlusselements (60) mit einer Kontaktfläche (52) eines Leistungshalbleiterbauelements (50) oder mit einer Leiterbahn (42) eines Substrats (40); als auch mit dem zweiten Leitungsabschnitt (64) druckkontaktiert verbunden sind und die Druckeinleitung mittels des Isolierstoffformkörpers (66) erfolgt.

4. Leistungshalbleitermodul nach Anspruch 1,
wobei der erste Leitungsabschnitt (62) als Tonnenfeder ausgebildet ist und in einer zugeordneten als Führung dienenden Ausformung (30) des Gehäuses (10) angeordnet ist.

5. Leistungshalbleitermodul nach Anspruch 1,
wobei der lsolierstoffformkörper (66) einen freigestellten beweglichen Abschnitt (82) mit einer Rastnase (84) und das Gehäuse (10) die zugeordnete Rastkante (22) aufweist.

6. Verfahren zur Herstellung eines Leistungshalbleitermoduls nach Anspruch 1,
wobei der zweite Leitungsabschnitt (64) als in Stanz- Biegetechnik hergestellter Metallformkörper ausgebildet ist.

7. Leistungshalbleitermodul nach Anspruch 1,
wobei das Gehäuse (10) auf einer Grundplatte (14) angeordnet ist, das Substrat (40) umschließt und in seinem Inneren, oberhalb des Substrats (40) Versteifungsstrukturen (32) aufweist, die mit den Ausformungen (30) verbunden sind.

## Claims

1. A power semiconductor module with a housing (10), at least one substrate (40), at least one power semiconductor component (50) disposed and connected in a manner appropriate to the circuit, connection elements (60) for load connections (16) and auxiliary connections having an electrically conductive connection to said power semiconductor component and being outwardly leading, wherein at least one connection element (60) is formed from a first spring-loaded line section (62) and a second rigid line section (64) and from an insulating material moulding (66), wherein at least one line section (62, 64) is partially connected to the insulating material moulding (66), **characterised in that** this insulating material moulding (66) has at least one stop surface (80) against an associated abutment (20) of the housing (10) and also part of a snap-click connection (22, 82, 84) to the housing (10).

2. The power semiconductor module according to claim 1, wherein the connection element (60) is connected to a contact surface (52) of a power semiconductor component (50) or to a strip conductor (42) of a substrate (40).

3. The power semiconductor module according to claim 1, wherein the first line section (62) of a connection element (60) is connected by pressure contact to a contact surface (52) of a power semiconductor component (50) or to a strip conductor (42) of a substrate (40) and also to the second line section (64) and pressure is applied by means of the insulating material moulding (66).

4. The power semiconductor module according to claim 1, wherein the first line section (62) is designed as a barrel spring and is disposed in an associated moulding (30) in the housing (10) acting as a guide.

5. The power semiconductor module according to claim 1, wherein the insulating material moulding (66) has an available movable section (82) with a lug (84) and the housing (10) has the associated catch edge (22).

6. A method of producing a power semiconductor module according to claim 1,
wherein the second line section (64) is designed as a metal moulding produced by means of punching and bending techniques.

7. The power semiconductor module according to claim 1, wherein the housing (10) is disposed on a baseplate (14), encloses the substrate (40) and has reinforcing structures (32) within above the substrate (40), said reinforcing structures being connected to the mouldings (30).

## Revendications

1. Module à semi-conducteurs de puissance comprenant un boîtier (10), au moins un substrat (40), au moins un composant à semi-conducteurs de puissance (50) disposé et relié de façon conforme au circuit, des éléments de raccordement (60) reliés à cet élément de façon électroconductrice et allant vers l'extérieur pour des branchements de charge (16) et des branchements auxiliaires, au moins un élément de raccordement (60) étant formé d'une première partie de ligne (62) conçue de façon élastique et d'une seconde partie de ligne (64) fixe et d'un corps de formage en matière isolante (66), au moins une partie de ligne (62, 64) étant reliée partiellement au corps de formage en matière isolante (66), **caractérisé en ce** qui :
ce corps de formage en matière isolante (66) présente au moins une surface de butée (80) par rapport à une contrebutée (20) associée du boîtier (10), et une partie d'une liaison à verrouillage et encliquetage (22, 82, 84) avec le boîtier (10).

2. Module à semi-conducteurs de puissance selon la revendication 1,
l'élément de raccordement (60) étant relié à une surface de contact (52) d'un composant à semi-conducteurs de puissance (50) ou à une piste conductrice (42) d'un substrat (40).

3. Module à semi-conducteurs de puissance selon la revendication 1,
la première partie de ligne (62) d'un élément de raccordement (60) étant reliée par contact de pression à une surface de contact (52) d'un composant à semi-conducteurs de puissance (50) ou à une piste conductrice (42) d'un substrat (40) de même qu'à la seconde partie de ligne (64) et l'application de pression s'effectuant au moyen du corps de formage en matière isolante (66).

4. Module à semi-conducteurs de puissance selon la revendication 1,
la première partie de ligne (62) étant conçue sous forme de ressort bombé et étant disposée dans une partie formée (30), associée, servant de guide, du boîtier (10).

5. Module à semi-conducteurs de puissance selon la revendication 1,
le corps de formage en matière isolante (66) présentant une partie (82) mobile libérée avec un ergot d'encliquetage (84) et le boîtier (10) présentant l'arête d'encliquetage (22) associée.

6. Procédé pour fabriquer un module à semi-conducteurs de puissance selon la revendication 1,
la seconde partie de ligne (64) étant conçue sous forme de corps de formage en métal fabriqué dans une technique de découpage et de cintrage.

7. Module à semi-conducteurs de puissance selon la revendication 1,
le boîtier (10) étant disposé sur une plaque de base (14), entourant le substrat (40) et présentant dans son intérieur, au-dessus du substrat (40), des structures de renfort (32) qui sont reliées aux parties formées (30).
